# EUROPÄISCHE PATENTSCHRIFT

(11) **EP 3 495 796 B1**
(45) Veröffentlichungstag und Bekanntmachung des Hinweises auf die Patenterteilung: **03.11.2021**
(21) Anmeldenummer: 18210292.1
(22) Anmeldetag: 05.12.2018
(51) Int. Cl.: G01R 31/01

(54) **VORRICHTUNG UND VERFAHREN ZUM PRÜFEN EINER LADEDOSE ZUM ZUFÜHREN ELEKTRISCHER ENERGIE ZU EINEM ENERGIESPEICHER EINES FAHRZEUGS**
DEVICE AND METHOD FOR CHECKING A CHARGING ADAPTER FOR SUPPLYING ELECTRICAL ENERGY TO AN ENERGY STORAGE OF A VEHICLE
DISPOSITIF ET PROCÉDÉ DE VÉRIFICATION D'UN ADAPTATEUR DE CHARGE POUR FOURNIR DE L'ÉNERGIE ÉLECTRIQUE À UN STOCKAGE D'ÉNERGIE D'UN VÉHICULE

(30) Priorität: 06.12.2017 DE 102017129061
(43) Veröffentlichungstag der Anmeldung: 12.06.2019
(73) Patentinhaber: Lisa Dräxlmaier GmbH, 84137 Vilsbiburg (DE)
(72) Erfinder: Seemüller, Markus, 84140 Gangkofen (DE)

(56) Entgegenhaltungen:
- DE-A1-102016 100 817
- KR-A- 20160 089 996
- US-A1- 2006 220 888
- US-A1- 2007 266 773

## Beschreibung

### Technisches Gebiet

Die vorliegende Erfindung betrifft eine Vorrichtung zum Prüfen einer Ladedose zum Zuführen elektrischer Energie zu einem Energiespeicher eines Fahrzeugs sowie ein Verfahren zum Prüfen einer Ladedose zum Zuführen elektrischer Energie zu einem Energiespeicher eines Fahrzeugs.

### Stand der Technik

Die vorliegende Erfindung wird im Folgenden hauptsächlich in Verbindung mit einem Hochvolt-Leitungsnetzwerk für Fahrzeuge beschrieben. Die Erfindung kann aber in jeder Anwendung genutzt werden, in welcher elektrische Leitungsnetze auf Dichtigkeit geprüft werden sollen und die elektrischen Leitungen als Druckluftleitungen nutzbar sind.

Sogenannte Plug-in-Hybridfahrzeuge (PHEV) sowie reine Elektrofahrzeuge (BEV) besitzen jeweils eine Ladedose, über die der Batterie des Kraftfahrzeugs elektrische Energie von außen zugeführt werden kann. Die Zufuhr kann dabei in der Regel über normale Haushaltssteckdosen oder auch über Schnellladestationen erfolgen. Unter einer Ladedose im Sinne der vorliegenden Patentanmeldung kann insbesondere eine Anschlussstelle eines zumindest teilweise elektrisch angetriebenen Kraftfahrzeugs, insbesondere eines Elektro- oder Hybrid-Kraftfahrzeugs, verstanden werden, an der eine externe Ladeleitung angeschlossen werden kann, um einer Batterie, allgemein auch als Energiespeicher bezeichnet, des Kraftfahrzeugs elektrische Energie von außerhalb des Kraftfahrzeugs zuzuführen.

Eine derartige Ladedose weist einen durch eine Wandung umgebenen, feuchtigkeitsdichten Raum auf, in dem elektrische Kontakte und eine Steuerungselektronik angeordnet sein können. Ein solcher feuchtigkeitsdichter Raum kann auch an anderen elektrischen oder elektronischen Geräten, beispielsweise in einem an einer Tragschiene anzuordnenden Elektronikgerät einer Industrieanlage oder dergleichen vorhanden sein, wobei innerhalb eines solchen feuchtigkeitsdichten Raums elektrische oder elektronische Komponenten, beispielsweise Schaltungsanordnungen auf einer Leiterplatte oder dergleichen angeordnet sein können.

Eine solche Ladedose wird Teil eines Leitungsnetzwerks, welches einen oder mehrere gedichtete Steckverbinder umfasst, die über Kabel mit der Ladedose verbunden sind. Dabei ist die Forderung, dass weder über einen Anschluss für einen Ladestecker oder Ladebuchse an der Ladedose noch über die angeschlossenen Kabel Feuchtigkeit in den feuchtigkeitsdichten Raum eindringen kann. Dies ist am Ende der Produktion zu überprüfen.

Hierzu sind Ladedosen bekannt, welche zusätzlich einen Zugang zu dem feuchtigkeitsdichten Raum für eine Druckprüfung aufweisen. Ein solches System wird beispielsweise in der Offenlegungsschrift DE 10 2016 100 817 A1 dargestellt. Nachteilig ist daran, dass der zusätzliche Zugang auch eine zusätzliche Fehlerquelle für eine Leckage sein kann.

CN 103 308 261 A beschreibt ein Online-Testsystem für Hochspannungskabelbaumversiegelung für Fahrzeuge, das eine Schnelldetektionsvorrichtung und einen luftdichten Leckdetektor umfasst. Das System kann die Leckrate des Hochspannungskabelbaums effektiv erfassen.

DE 103 56 039 A1 betrifft eine Einblasvorrichtung zur Überprüfung einer Kabelmuffe auf Dichtigkeit, welche in einer unbelegten Kabeldurchführungsöffnung der Kabelmuffe anordbar ist, eine Kabelmuffe mit einer in einer unbelegten Kabeldurchführungsöffnung angeordneten Einblasvorrichtung und ein Verfahren zur Überprüfung von zum Verlegen bereiter Kabelmuffen auf deren Dichtigkeit insbesondere gegenüber Flüssigkeiten.

Aus der DE 10 2016 100 817 A1 ist ein Gehäuseteil für eine elektrische oder elektronische Einrichtung bekannt. Um die Dichtigkeit des Gehäuses zu überprüfen, wird an dem Gehäuseteil eine Prüfstelle bereitgestellt, die einen Zugang zu dem feuchtigkeitsdichten Raum ermöglicht.

Die KR 2016 0 089 996 A beschreibt ein Verfahren zum Testen der Luftdichtheit eines Batteriepacks.

### Beschreibung der Erfindung

Eine Aufgabe der Erfindung ist es daher, unter Einsatz konstruktiv möglichst einfacher Mittel ein Prüfsystem und ein Prüfverfahren zu schaffen, welche ohne Änderungen eines Leitungsnetzwerks dessen Dichtigkeit überprüfen.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben. Insbesondere können die unabhängigen Ansprüche einer Anspruchskategorie auch analog zu den abhängigen Ansprüchen einer anderen Anspruchskategorie weitergebildet sein.

Gemäß einem ersten Aspekt wird ein Prüfsystem umfassend ein Leitungsnetzwerk umfassend einen gedichteten Steckverbinder, eine Ladedose zur Montage an einem zumindest teilweise elektrisch angetriebenem Fahrzeug sowie ein den Steckverbinder und die Ladedose verbindendes Kabel, wobei das Kabel zumindest einen elektrischen Leiter sowie eine den zumindest einen elektrischen Leiter umhüllende Isolierung aufweist, und eine Dichtigkeits-Prüfeinrichtung für die Ladedose zum Zuführen elektrischer Energie zu einem Energiespeicher des Fahrzeugs, umfassend einen Prüfadapter, der den gedichteten Steckverbinder kontaktiert, eine mit dem Prüfadapter verbundene Fluidversorgung, die eingerichtet ist, ein Fluid am Prüfadapter bereitzustellen, und eine Messeinrichtung zur Detektion einer Dichtigkeit der Ladedose und/oder des Leitungsnetzwerks basierend auf dem bereitgestellten Fluid.

Eine Dichtigkeits-Prüfeinrichtung für eine Ladedose eines Leitungsnetzwerks umfasst einen Prüfadapter, eine Fluidversorgung sowie eine Messeinrichtung. Der Prüfadapter ist eingerichtet einen gedichteten Steckverbinder des Leitungsnetzwerks zu kontaktieren. Dabei umfasst das Leitungsnetzwerk den gedichteten Steckverbinder, die Ladedose zur Montage an einem zumindest teilweise elektrisch angetriebenen Fahrzeug sowie ein Kabel, welches die Ladedose mit dem gedichteten Steckverbinder verbindet. Unter dem Kabel kann eine Leitung verstanden werden. Das Kabel weist zumindest einen elektrischen Leiter sowie eine den zumindest einen elektrischen Leiter umhüllende Isolierung auf. Bei einem Kabel mit einer Mehrzahl von elektrischen Leitern können diese jeweils eine Isolierung aufweisen und die Mehrzahl von elektrischen Leitern von einer gemeinsamen Isolierung bzw. Schutzhülle umgeben sein. Die Fluidversorgung ist mit dem Prüfadapter verbunden und dabei eingerichtet, an dem Prüfadapter ein Fluid bereitzustellen, welches über den gedichteten Steckverbinder in das Leitungsnetzwerk geleitet wird. Die Messeinrichtung ist eingerichtet eine Dichtigkeit der Ladedose und optional ergänzend eine Dichtigkeit des Leitungsnetzwerks basierend auf dem bereitgestellten Fluid zu detektieren.

Ein erfindungsgemäßes Verfahren zum Prüfen einer Ladedose zum Zuführen elektrischer Energie zu einem Energiespeicher eines Fahrzeugs umfasst die Schritte des Kontaktierens, des Bereitstellens, des Leitens sowie des Detektierens. Im Schritt des Kontaktierens wird ein gedichteter Steckverbinder eines Leitungsnetzwerks kontaktiert. Das Leitungsnetzwerk umfasst den gedichteten Steckverbinder, die Ladedose sowie ein den Steckverbinder und die Ladedose verbindendes Kabel. Im Schritt des Bereitstellens wird ein Fluid an dem gedichteten Steckverbinder mittels eines Prüfadapters bereitgestellt. Das bereitgestellte Fluid wird im Schritt des Leitens von dem gedichteten Steckverbinder über das Kabel zur Ladedose geleitet. Im Schritt des Detektierens wird eine Dichtigkeit der Ladedose und optional gleichzeitig eine Dichtigkeit des Leitungsnetzwerks basierend auf dem bereitgestellten Fluid detektiert.

Mit anderen Worten wird über den Steckverbinder Druckluft oder ein anderer gasförmiger Stoff eingespeist, welches über das Kabel in die Ladedose strömt. Mittels der Messeinrichtung kann eine eventuelle Leckage gemessen werden. Während einer Druckaufbauphase besteht eine hohe Durchflussrate, wenn alle Komponenten und die Verbindung der Komponenten zu dem Leitungsnetzwerk dicht sind, so pendelt sich der Durchflusswert nach der Druckaufbauphase auf einen Wert nahe 0 ml/min oder alternativ auf einen tolerierbaren Grundleckagewert ein. Das Kabel zwischen dem Steckverbinder und der Ladedose wird hierbei quasi als Druckluftleitung beziehungsweise Fluidleitung für die Dichtigkeitsprüfung der dahinter verbauten Komponente bzw. Komponenten verwendet.

In einer Ausführungsform handelt es sich bei dem Leitungsnetzwerk um ein Hochvolt-Leitungsnetzwerk. Somit handelt es sich bei dem Steckverbinder um einen Hochvolt-Steckverbinder, bei der Ladedose um eine Hochvolt-Ladedose sowie bei dem verbindenden Kabel um ein Hochvolt-Kabel. In diesem Fall ist der Prüfadapter eingerichtet, den Hochvolt-Steckverbinder zu kontaktieren. Der Kontakt zwischen dem Prüfadapter und dem Steckverbinder ist fluiddicht ausgeführt.

Das Leitungsnetzwerk kann eine Mehrzahl von gedichteten Steckverbindern umfassen, die jeweils mit zumindest einem Kabel mit der Ladedose verbunden sind. So kann ein gedichteter Steckverbinder mit zwei oder mehr Kabeln mit der Ladedose verbunden sein, beispielsweise um Wechselstrom bzw. einen Mehrphasenstrom von der Ladedose zu dem Steckverbinder oder umgekehrt zu leiten. Der Prüfadapter kann dabei eingerichtet sein die Mehrzahl von gedichteten Steckverbindern zu kontaktieren. Das über den Prüfadapter eingeleitete Fluid kann dabei über die Mehrzahl von Steckverbindern in das Leitungsnetzwerk eingeleitet werden. So kann vorteilhafterweise auch eine komplexere Struktur des Leitungsnetzwerks überprüft werden.

Das Fluid kann mit einem Überdruck im Vergleich zum Umgebungsdruck bereitgestellt und in das Leitungsnetzwerk eingespeist werden. So kann das Fluid mit einem Druck, der zumindest dem 1,05-fachen oder 1,07-fachen Wert des Umgebungsdrucks entspricht, bereitgestellt werden. So kann der Überdruck beispielsweise in etwa 0,7 bar oder 1 psig entsprechen. So kann das Fluid mit einem Druck, der zumindest dem 1,1-fachen Wert des Umgebungsdrucks entspricht, bereitgestellt werden. Weiterhin kann das Fluid mit einem Druck, der zumindest dem 1,2-fachen Wert oder mehr des Umgebungsdrucks entspricht, bereitgestellt werden. Mit anderen Worten kann das Fluid mit einem Druck, der größer 10 %, insbesondere größer 20 % über dem Umgebungsdruck liegt, bereitgestellt werden.

Die Dichtigkeits-Prüfeinrichtung kann einen Durchflusssensor umfassen. So kann der Durchflusssensor Teil der Messeinrichtung sein. Mit dem Durchflusssensor kann eine Durchflussmenge des bereitgestellten Fluid gemessen und überwacht werden. Dabei kann die Durchflussmenge mit einem vordefinierten Schwellwert verglichen werden. Ein Verlauf der Durchflussmenge über die Zeit kann sich dabei nach einer Einschwingzeit auf einen konstanten Wert einstellen. Durch einen Vergleich mit einem Schwellwert kann dabei einfach eine Aussage zur Dichtigkeit getroffen werden. In einem optimalen System kann sich die Durchflussmenge auf einen Wert von in etwa 0 ml/min nach der Einschwingzeit einstellen, sofern das Leitungsnetzwerk und insbesondere die Ladedose dicht sind. Somit kann eine "in Ordnung"-Information bereitgestellt werden. Wenn sich die Durchflussmenge nach der Einschwingzeit auf einen Wert größer eines vordefinierten Schwellwerts von beispielsweise 100 ml/min oder 300 ml/min oder 600 ml/min einstellt, so kann auf eine Undichtigkeit bzw. eine Leckage geschlossen werden.

In einer besonderen Ausführungsform kann ein gasförmiges Fluid bereitgestellt werden. So kann es sich bei dem Fluid um Luft handeln. Insbesondere kann es sich bei dem Fluid um Helium oder Wasserstoff handeln oder das Fluid kann einen im Verhältnis zur normalen Luft erhöhten Anteil von Helium oder Wasserstoff aufweisen. So kann mit einem Gassensor ein Austritt von Helium oder Wasserstoff detektiert werden und somit eine Leckage diagnostiziert werden.

In einer weiteren besonderen Ausführungsform kann das Fluid farbig sein oder einen von Luft verschiedenen Brechungsindex aufweisen oder alternativ eine von der Umgebungsluft abweichende Temperatur aufweisen dabei sollte der Farbunterschied, der Unterschied im Brechungsindex oder der Temperaturunterschied entsprechend hoch gewählt sein, sodass durch die Messeinrichtung eine durch eine Leckage bedingte Veränderung in der Umgebung des Leitungsnetzwerk detektierbar ist. So kann die Messeinrichtung einen hieran angepassten Sensor aufweisen. So kann es sich um eine optische Messtechnik bzw. um einen optischen Sensor wie beispielsweise eine Kamera handeln.

Die Dichtigkeits-Prüfeinrichtung kann weiterhin Prüfmittel für einen elektrischen Test des Leitungsnetzwerks aufweisen. So kann der Prüfadapter Hochvolt-Kontaktelemente zum elektrischen Kontaktieren und Prüfen des Leitungsnetzwerks umfassen. In einer solchen Ausführungsform kann die Messeinrichtung weiterhin elektrische Messmittel aufweisen, um einerseits das Leitungsnetzwerk mit einer Prüfspannung und alternativ oder ergänzend mit einem Prüfstrom zu beaufschlagen und entsprechend messtechnisch auszuwerten.

Die vorgestellte Idee schafft eine Möglichkeit ein komplettes Hochvolt-Kabelnetzwerk auf einmal auf ihre Dichtigkeit zu prüfen, insbesondere inklusive der Isolierung der Kabel.

### Kurze Figurenbeschreibung

Nachfolgend wird ein vorteilhaftes Ausführungsbeispiel der Erfindung unter Bezugnahme auf die begleitenden Figuren erläutert. Es zeigen:
- Fig. 1: eine schematische Darstellung einer an einem Leitungsnetzwerk mit einer Ladedose angeordnete Dichtigkeits-Prüfeinrichtung gemäß einem ersten Ausführungsbeispiel der vorliegenden Erfindung;
- Fig. 2: eine schematische Darstellung einer an einem Leitungsnetzwerk mit einer Ladedose angeordnete Dichtigkeits-Prüfeinrichtung gemäß einem zweiten Ausführungsbeispiel der vorliegenden Erfindung;
- Fig. 3: eine schematische Darstellung einer an einem Leitungsnetzwerk mit einer Ladedose angeordnete Dichtigkeits-Prüfeinrichtung gemäß einem dritten Ausführungsbeispiel der vorliegenden Erfindung;
- Fig. 4: eine vereinfachte Darstellung einer an einem Leitungsnetzwerk mit einer Ladedose angeordnete Dichtigkeits-Prüfeinrichtung gemäß einem vierten Ausführungsbeispiel der vorliegenden Erfindung;
- Fig. 5: ein Prüfadapter an einem gedichteten Steckverbinder gemäß einem Ausführungsbeispiel der vorliegenden Erfindung;
- Fig. 6: ein Prüfadapter an einem gedichteten Steckverbinder gemäß einem weiteren Ausführungsbeispiel der vorliegenden Erfindung;
- Fig. 7: eine schematische Darstellung eines Fahrzeugs mit einer Ladedose und einem die Ladedose umfassenden Leitungsnetzwerk; und
- Fig. 8: ein Ablaufdiagramm eines Verfahrens zum Prüfen einer Ladedose zum zuführen elektrischer Energie zu einem Energiespeicher eines Fahrzeugs gemäß einem Ausführungsbeispiel der vorliegenden Erfindung.

Die Figuren sind lediglich schematische Darstellungen und dienen nur der Erläuterung der Erfindung. Gleiche oder gleichwirkende Elemente sind durchgängig mit den gleichen Bezugszeichen versehen.

### Detaillierte Beschreibung

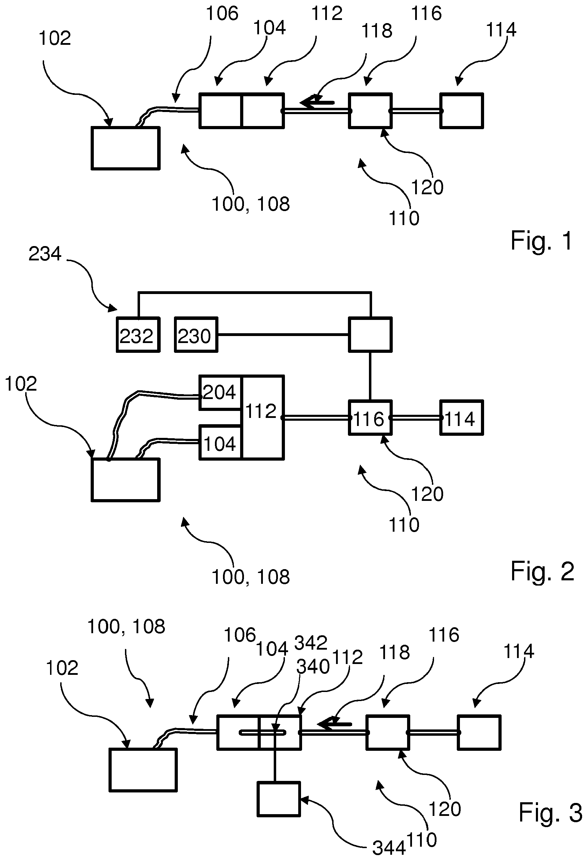

Fig. 1 zeigt ein Leitungsnetzwerk 100 mit einer Ladedose 102, einem gedichteten Steckverbinder 104 sowie einem die Ladedose 102 und den gedichteten Steckverbinder 104 verbindenden Kabel 106. Die Ladedose 102 ist eingerichtet, elektrische Energie zu einem hier nicht dargestellten Energiespeicher eines Fahrzeugs zuzuleiten. Das Kabel 106 ist gemäß Spezifikation fluiddicht mit der fluiddichten Ladedose 102 verbunden. Ebenso ist das Kabel 106 gemäß Spezifikation fluiddicht mit dem gedichteten Steckverbinder 104 verbunden. Bei dem Leitungsnetzwerk 100 handelt es sich um einen Prüfling 108, der auf Dichtigkeit geprüft werden soll. So ist weiterhin eine Dichtigkeits-Prüfeinrichtung 110 mit dem Steckverbinder 104 des Leitungsnetzwerks 100 verbunden. Die Dichtigkeits-Prüfeinrichtung 110 umfasst einen Prüfadapter 112, eine Fluidversorgung 114 sowie eine Messeinrichtung 116. Der Prüfadapter 112 kontaktiert den Steckverbinder 104. Dabei wird eine fluiddichte Verbindung zwischen beiden hergestellt. Die Fluidversorgung 114 ist eingerichtet, am Prüfadapter 112 ein Fluid 118 bereitzustellen. In dem dargestellten Ausführungsbeispiel ist zwischen der Fluidversorgung 114 und dem Prüfadapter 112 die Messeinrichtung 116 angeordnet. Das von der Fluidversorgung 114 bereitgestellte Fluid 118 wird über die Messeinrichtung 116 zum Prüfadapter 112 geleitet. Die Messeinrichtung 116 ist eingerichtet, eine Dichtigkeit der Ladedose 102 basierend auf einer Auswertung physikalischer Größen des bereitgestellten Fluids 118 zu bewerten.

In einem bevorzugten Ausführungsbeispiel handelt es sich bei dem Leitungsnetzwerk 100 um ein Hochvolt-Leitungsnetzwerk. So können die Kabel 106 eine Silikon-Isolierung aufweisen.

Die Dichtigkeits-Prüfeinrichtung 110 ist eingerichtet, den Prüfling 108 auf Dichtigkeit zu prüfen. In der vereinfachten Darstellung in Fig. 1 ist die Ladedose 102 nur schematisch dargestellt. Die Ladedose 102 hat rückseitig einen abgedichteten Raum, in dem sich Kontakte und eine Leiterplatte befindet. Es besteht keine direkte Möglichkeit, die Ladedose im abgedichteten Bereich mit Druckluft zu beaufschlagen, um eine Prüfung durchzuführen. In dem dargestellten Ausführungsbeispiel weist die Ladedose 102 keinen "Einspeisepunkt" auf, über den Druckluft eingespeist werden könnte und somit die Dichtigkeit überprüft werden könnte. Ein solcher Einspeisepunkt stellt auch eine zusätzliche mögliche Fehlerquelle dar, da auch dieser undicht sein könnte, insbesondere nach einem Testlauf. So kann eine konventionelle Druckprüfung über die Kontaktseite der Ladedose 102 nicht die gesamte Dichtigkeit der Ladedose 102 sicherstellen bzw. sicher überprüfen, da rückseitig verbaute Dichtungen nicht abgeprüft würden.

In einer Variante umfasst die Messeinrichtung 116 einen Durchflusssensor 120. Der Durchflusssensor 120 ist eingerichtet, eine Durchflussmenge des Fluids 118 zu erfassen. Weiterhin ist die Messeinrichtung 116 eingerichtet, die Dichtigkeit unter Verwendung der Durchflussmenge zu bestimmen. Nach einer Druckaufbauphase mit einer hohen Durchflussrate pendelt sich der Durchflusswert auf einen Wert ein. Die Zeitdauer der Druckaufbauphase wird auch als Einschwingzeit bezeichnet. Wenn dieser Wert unterhalb eines vordefinierten Schwellwerts liegt, wird der Prüfling 108 als dicht oder "in Ordnung" bezeichnet.

Fig. 2 zeigt ein im Vergleich zum in Fig. 1 dargestellten ersten Ausführungsbeispiel erweitertes zweites Ausführungsbeispiel einer Dichtigkeits-Prüfeinrichtung 110. Das Leitungsnetzwerk 100 weist einen zweiten Steckverbinder 204 auf. Der zweite Steckverbinder 204 ist über zwei Kabel 206 mit der Ladedose 102 verbunden. Der Prüfadapter 112 ist ausgebildet, sowohl den ersten Steckverbinder 104 als auch den zweiten Steckverbinder 204 fluiddicht zu kontaktieren. Das Konzept ist skalierbar. In einer ersten Variante ist der Prüfadapter 112 ausgebildet, alle Steckverbinder 104, 204 eines Leitungsnetzwerks 100 zu kontaktieren. In einer zweiten Variante ist der Prüfadapter 112 ausgebildet, zumindest einen ersten Steckverbinder 104 zu kontaktieren, die übrigen Steckverbinder 204 des Leitungsnetzwerks 100 werden mit nicht dargestellten Kappen fluiddicht verschlossen.

In einer Variante ist das Fluid 118 gasförmig. So kann es sich bei dem Fluid um Luft handeln in einer besonderen Variante weist das Fluid einen erhöhten Anteil Helium oder Wasserstoff auf, welcher mit einem Gassensor 230 detektierbar ist. So ist der Gassensor 230 eingerichtet eine Emission des Helium oder Wasserstoff umfassenden Fluids aus der Ladedose 102 bzw. dem Leitungsnetzwerk 100 zu sensieren und entsprechend eine Leckage anzuzeigen. Eine angezeigte Leckage widerspricht der Forderung nach Dichtigkeit. In diesem Fall würde der Prüfling 108 aussortiert.

In dem in Fig. 2 gezeigten zweiten Ausführungsbeispiel umfasst die Messeinrichtung 116 neben dem Gassensor 230 zusätzlich einen visuellen Sensor 232. Bei dem visuellen Sensor 232 kann es sich um eine Kamera 234 insbesondere zur Erfassung von Farbbildern handeln. Dabei ist denkbar, dass das bereitgestellte Fluid 118 eingefärbt ist und somit eine Leckage bzw. Undichtigkeit des Prüflings 108 erkennbar ist, wenn ein entsprechend eingefärbtes Fluid austritt. Dabei ist eine Auswertung der Farbinformation (eventuell sogar rein statistisch auf einem Histogramm basierend) ausreichend, um die Dichtigkeit zu überprüfen.

Fig. 3 erweitert die bereits beschriebenen Ausführungsbeispiele um zusätzliche Kontaktelemente 340 zum elektrischen Kontaktieren des Leitungsnetzwerks 100. Wenn es sich bei dem Leitungsnetzwerk 100 um ein Hochvolt-Leitungsnetzwerk handelt, so sind auch die Kontaktelemente 340 als Hochvolt-Kontaktelemente 342 ausgebildet. In diesem Fall wird die Dichtigkeits-Prüfeinrichtung 100 um eine zusätzliche elektrische Prüfeinrichtung 344 erweitert, welche eingerichtet ist, den Prüfling 108 parallel zur Dichtigkeitsprüfung auch elektrisch zu testen.

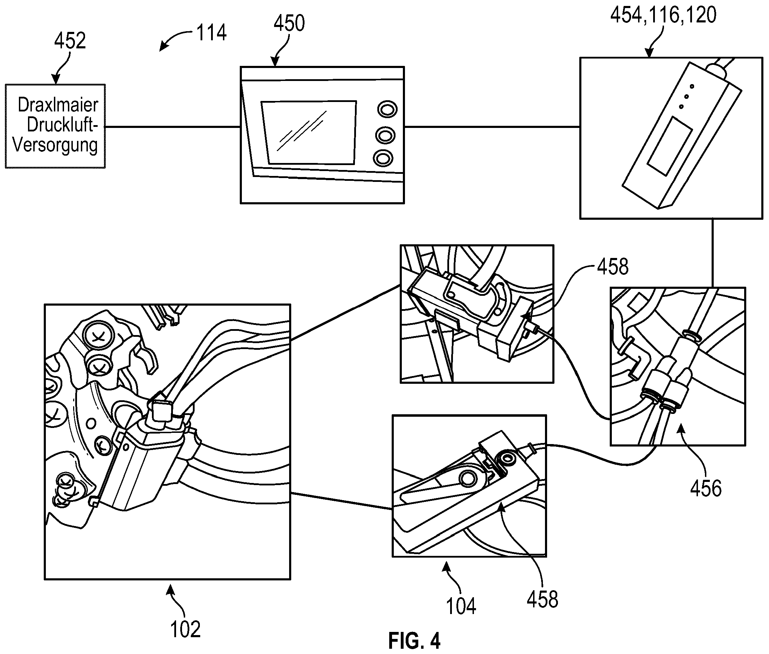

Das gesamte Leitungsnetzwerk 100, auch als Ladeleitungssatz bezeichnet, bildet ein luftdichtes Netzwerk. Die Ladedose 102 kann nicht direkt mit Luft beaufschlagt werden, um die Dichtigkeit zu messen. Das hier beschriebene Konzept sieht vor, dass gesamte Leitungsnetzwerk einer Dichtigkeitsprüfung zu unterziehen. Als Schnittstellen zu dem Prüfsystem, d. h. der Dichtigkeits-Prüfeinrichtung 110 werden die Steckverbinder 104, 204 genutzt. Die Messeinrichtung ist beispielsweise in dem in Fig. 4 dargestellten Ausführungsbeispiel eingerichtet, über die Ermittlung eines Durchflusswertes in l/min bei einem Überdruck von 0,2 bar Rückschlüsse auf die Dichtigkeit des Systems zu ziehen. In dem Ausführungsbeispiel in Fig. 4 erfolgt eine Einspeisung des Fluids 118 über ein Druckluftregelgerät 450. Das Fluid 118 wird hier als Druckluft von einer zentralen Druckluftversorgung 452 bereitgestellt. Alternativ ist ein handelsübliches Druckregelventil vorgesehen. Zwischen der Druckeinspeisung, d. h. Druckluftversorgung 452 und Druckluftregelgerät 450 oder alternativ Druckregelventil, und den Steckverbindern 104, 204, hier als Hochvolt-Stecker ausgebildet, befindet sich ein Durchflussmesser 454, der den Durchfluss und somit die Leckage ermittelt. Der Durchflussmesser 454 stellt somit eine einen Durchflusssensor 120 umfassende Messeinrichtung 116 dar.

Das Fluid 118 wird nach dem Durchflussmesser 454 über einen T-Verteiler 456 auf zwei separate Kontaktbuchsen 458 geleitet. Der T-Verteiler 456 und die zwei separaten Kontaktbuchsen 458 sind Teil des Prüfadapters 112. Die Kontaktbuchsen 458 sind eingerichtet, die Steckverbinder 104, 204 fluiddicht zu kontaktieren. Mit anderen Worten sind die Kontaktbuchsen 458 zur Abdichtung im Prüfadapter 112 verbaut. Die Kontaktbuchsen 458, auch als Einlegeteil bezeichnet, entsprechen in der Geometrie im Dichtflächenbereich den Einlegeteilen von Prüfadaptern 112 bzw. entsprechenden Gegensteckern. Über die Kontaktbuchsen 458 werden die Steckverbinder 104, 204 mit Druckluft, bzw. dem Fluid 118 beaufschlagt. Das so eingespeiste Fluid 118 wird über die Kabel 106, 206, welche in dem dargestellten Ausführungsbeispiel als Hochvolt-Leitungen ausgebildet sind, in die Ladedose 102 geführt.

Der Durchflussmesser 454 weist einen Messbereich von 0 ml/min bis 999 ml/min auf. An der Ladedose 102 kann beispielsweise eine weitere PE-Leitung vorgesehen sein, über welche eine geringe Menge des Fluids 118 entweichen kann. In einem solchen Fall kann sich die Durchflussmenge beispielsweise auf einen Wert von 30 ml/min einpendeln. In einem solchen Fall könnte man den Schwellwert auf 35 ml/min definieren und bei Werten oberhalb des Schwellwerts eine ungewollte Leckage detektieren. Bei einem alternativen Leitungsnetzwerk 100 kann der Schwellwert beispielsweise bei 100 ml/min bei einem Überdruck von 0,2 bar festgelegt werden.

In Versuchen hat sich gezeigt, dass bei 0,2 bar Überdruck innerhalb weniger als 1 Minute ein ausreichendes Luftvolumen eingespeist werden kann, bis sich ein entsprechender Gegendruck in der Ladedose 102 bzw. in dem Leitungsnetzwerk 100 aufgebaut hat. In diesem Fall würde man die Einschwingzeit mit 1 Minute definieren.

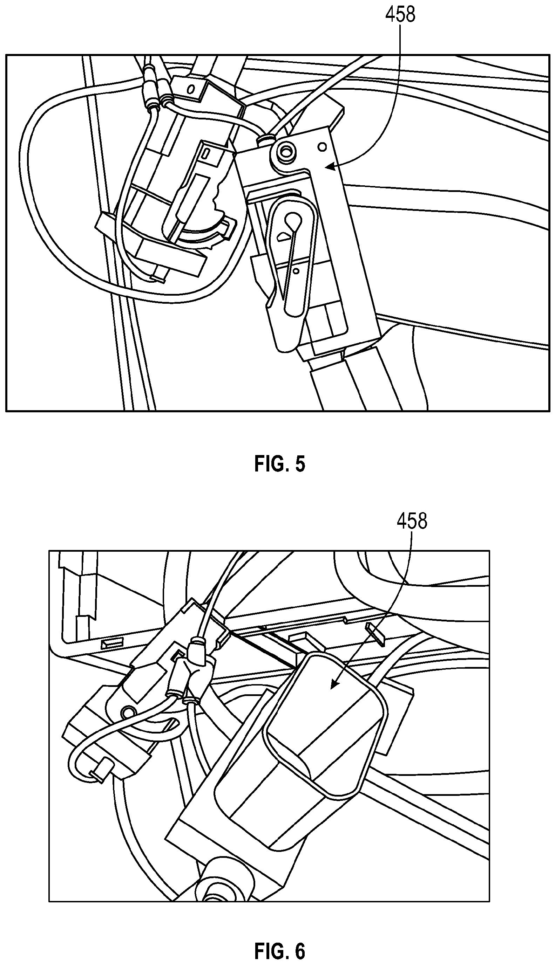

Fig. 5 und Fig. 6 zeigen Varianten von Kontaktbuchsen 458 als Teil eines Prüfadapters 112. Die Kontaktbuchsen 458 entsprechen in ihrer Geometrie Gegensteckern zu den Steckverbindern 104, 204 und stellen eine fluiddichte Verbindung zwischen dem Prüfadapter 112 und den Steckverbindern 104, 204 her, sodass das Fluid 118 in das Leitungsnetzwerk 100 geleitet werden kann.

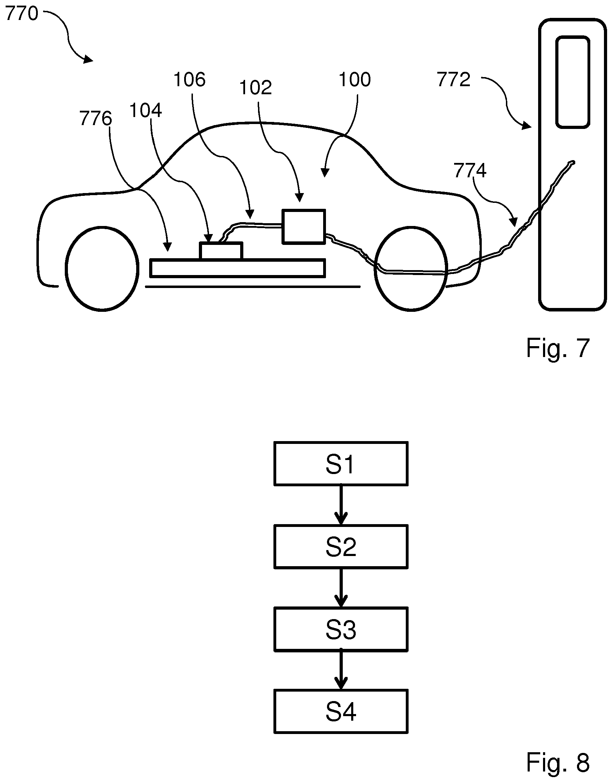

Fig. 7 zeigt ein Fahrzeug 770 mit einer Ladedose 102 an einer Ladestation 772. Die Ladestation 772 ist über ein Ladekabel 774 mit der Ladedose 102 des Fahrzeugs 770 verbunden. Hierzu weist das Ladekabel 774 an dem der Ladestation 772 entfernten Ende einen nicht dargestellten Ladestecker zum Kontaktieren der Ladedose 102 auf. Die Ladedose 102 ist Teil eines Leitungsnetzwerks 102, wie dieses exemplarisch in Fig. 1 bis

Fig. 3 beschrieben ist. Ein Steckverbinder 104 ist mit einem Energiespeicher 776 des Fahrzeugs 770 verbunden. Somit zeigt Fig. 7 eine schematische Ansicht eines Ladesystems, wie es zum Laden eines elektrisch betriebenen Fahrzeugs, kurz bezeichnet als Elektrofahrzeug oder BEV oder PHEV, verwendet wird.

Die Ladedose 102 kann auch als Ladebuchse bezeichnet werden, in die ein Gegenstecker in Form eines elektrisch mit der Ladestation 772 verbundenen Ladesteckers am Ende des Ladekabels 774 eingesteckt werden kann. Das Ladekabel 774 ist elektrisch mit der Ladestation verbunden, sodass durch eine Verbindung zwischen Ladedose 102 und dem nicht dargestellten Ladestecker eine elektrische Verbindung zwischen der Ladestation 772 und dem Fahrzeug 770 hergestellt werden kann, und Ladeströme zum Aufladen des Energiespeichers 776 des Fahrzeugs 770 übertragen werden können.

Fig. 8 zeigt einen Ablaufplan eines Verfahrens zum Prüfen einer Ladedose zum Zuführen elektrischer Energie zu einem Energiespeicher eines Fahrzeugs mit den Schritten Kontaktieren S1, Bereitstellen S2, Leiten S3 sowie Detektieren S4.

Im Schritt S1 des Kontaktierens wird ein gedichteter Steckverbinder eines Leitungsnetzwerks umfassend den gedichteten Steckverbinder, eine Ladedose zur Montage an einem zumindest teilweise elektrisch angetriebenem Fahrzeug sowie ein den Steckverbinder und die Ladedose verbindendes Kabel kontaktiert. Im Schritt S2 wird an dem Steckverbinder ein Fluid bereitgestellt, welches im Schritt S3 des Leitens von dem Steckverbinder über das Kabel zur Ladedose geleitet wird. Im Schritt S4 des Detektierens wird eine Dichtigkeit der Ladedose oder des Leitungsnetzwerks basierend auf dem bereitgestellten Fluid detektiert.

### BEZUGSZEICHENLISTE

- 100: Leitungsnetzwerk
- 102: Ladedose
- 104, 204: Steckverbinder
- 106, 206: Kabel, Leitung
- 108: Prüfling
- 110: Dichtigkeits-Prüfeinrichtung
- 112: Prüfadapter
- 114: Fluidversorgung
- 116: Messeinrichtung
- 118: Fluid
- 120: Durchflusssensor

- 230: Gassensor
- 232: visueller Sensor
- 234: Kamera, Farbkamera

- 340: Kontaktelement
- 342: Hochvolt-Kontaktelement

- 450: Drockluftregelgerät
- 452: zentrale Druckluftversorgung
- 454: Durchlussmesser
- 456: T-Verteiler
- 458: Kontaktbuchsen

- 770: Fahrzeug
- 772: Ladestation
- 774: Ladekabel
- 776: Energiespeicher

- S1, S2, S3: Verfahrensschritte

## Patentansprüche

1. Prüfsystem umfassend
ein Leitungsnetzwerk (100) umfassend einen gedichteten Steckverbinder (104; 204), eine Ladedose (102) zur Montage an einem zumindest teilweise elektrisch angetriebenem Fahrzeug (770) sowie ein den Steckverbinder (104; 204) und die Ladedose (102) verbindendes Kabel (106; 206), wobei das Kabel (106; 206) zumindest einen elektrischen Leiter sowie eine den zumindest einen elektrischen Leiter umhüllende Isolierung aufweist, und
eine Dichtigkeits-Prüfeinrichtung (110) für die Ladedose (102) zum Zuführen elektrischer Energie zu einem Energiespeicher (776) des Fahrzeugs (770), umfassend:
a. einen Prüfadapter (112), der den gedichteten Steckverbinder (104; 204) kontaktiert,
b. eine mit dem Prüfadapter (112) verbundene Fluidversorgung (114), die eingerichtet ist, ein Fluid (118) am Prüfadapter (112) bereitzustellen, und
c. eine Messeinrichtung (116) zur Detektion einer Dichtigkeit der Ladedose (102) und, optional, des Leitungsnetzwerks (100) basierend auf dem bereitgestellten Fluid (118).

2. Prüfsystem gemäß Anspruch 1, wobei das Leitungsnetzwerk (100) ein Hochvolt-Leitungsnetzwerk ist und der Prüfadapter eingerichtet ist, den gedichteten Hochvolt-Steckverbinder zu kontaktieren.

3. Prüfsystem gemäß einem der vorangegangenen Ansprüche, bei der der Prüfadapter (112) eingerichtet ist zum Kontaktieren zumindest eines zweiten gedichteten Steckverbinders (204), der über zumindest ein zweites Kabel (206) mit der Ladedose (102) verbunden ist.

4. Prüfsystem gemäß einem der vorangegangenen Ansprüche, bei der die Fluidversorgung (114) eingerichtet ist, das Fluid (118) zumindest mit einem Druck mit dem 1,05-fachen Wert des Umgebungsdrucks bereitzustellen, oder das Fluid (118) zumindest mit einem Druck mit dem 1,1-fachen Wert des Umgebungsdrucks bereitzustellen, oder das Fluid (118) zumindest mit einem Druck mit dem 1,2-fachen Wert des Umgebungsdrucks bereitzustellen.

5. Prüfsystem gemäß einem der vorangegangenen Ansprüche, bei der die Messeinrichtung (116) einen Durchflusssensor (120) umfasst und eingerichtet ist, eine Durchflussmenge und/oder einen Druck des bereitgestellten Fluids (118) zu überwachen und die Dichtigkeit unter Verwendung der Durchflussmenge und/oder dem Druck zu bestimmen.

6. Prüfsystem gemäß dem vorangegangenen Anspruch, bei der die Messeinrichtung (116) eingerichtet ist, die Durchflussmenge mit einem Schwellwert zu vergleichen, wobei die Dichtigkeit detektiert wird, wenn die Durchflussmenge, insbesondere nach einer Einschwingzeit, kleiner dem Schwellwert ist.

7. Prüfsystem gemäß einem der vorangegangenen Ansprüche, bei der das Fluid (118) gasförmig ist, insbesondere bei der das Fluid (118) Helium, Wasserstoff oder im Wesentlichen Luft umfasst.

8. Prüfsystem gemäß dem vorangegangenen Anspruch, bei der die Messeinrichtung (116) einen Gassensor (230) umfasst, um eine eine Leckage anzeigende Emmission zu detektieren.

9. Prüfsystem gemäß einem der vorangegangenen Ansprüche, bei der die Messeinrichtung (116) einen visuellen Sensor (232, 234) umfasst, um eine eine Leckage anzeigende Emmission zu detektieren.

10. Prüfsystem gemäß einem der vorangegangenen Ansprüche, bei der im Prüfadapter (112) Hochvolt-Kontaktelemente (342) zum elektrischen Kontaktieren und Prüfen des Leitungsnetzwerks (100) umfasst sind.

11. Verfahren zum Prüfen einer Ladedose (102) zum Zuführen elektrischer Energie zu einem Energiespeicher (776) eines Fahrzeugs (770), mit den folgenden Schritten:
a. Kontaktieren (S1) eines gedichteten Steckverbinders (104; 204) eines Leitungsnetzwerks (100) umfassend den gedichteten Steckverbinder (104; 204), eine Ladedose (102) zur Montage an einem zumindest teilweise elektrisch angetriebenem Fahrzeug (770) sowie ein den Steckverbinder (104; 204) und die Ladedose (102) verbindendes Kabel (106; 206), wobei das Kabel (106; 206) zumindest einen elektrischen Leiter sowie eine den zumindest einen elektrischen Leiter umhüllende Isolierung aufweist,
b. Bereitstellen (S2) eines Fluids (118) an dem gedichteten Steckverbinder (104; 204) mittels eines Prüfadapters (112),
c. Leiten (S3) des bereitgestellten Fluids (118) von dem gedichteten Steckverbinder (104; 204) über das Kabel (106; 206) zur Ladedose (102), und
d. Detektieren (S4) einer Dichtigkeit der Ladedose (102) und, optional, des
Leitungsnetzwerks (100) basierend auf dem bereitgestellten Fluid (118).

12. Verfahren nach Anspruch 11, bei dem im Schritt (S2) des Bereitstellens das Fluid (118) zumindest mit einem 1,07-fachen Wert des Umgebungsdrucks bereitgestellt wird, insbesondere das Fluid (118) zumindest mit einem 1,2-fachen Wert des Umgebungsdrucks bereitgestellt wird.

13. Verfahren nach einem der Ansprüche 11 oder 12, bei dem im Schritt (S4) des Detektierens eine Durchflussmenge und/oder ein Druck des bereitgestellten Fluids überwacht werden und eine Dichtigkeit unter Verwendung der Durchflussmenge und/oder des Drucks bestimmt wird.

14. Verfahren nach Anspruch 13, bei dem im Schritt (S4) des Detektierens die Durchflussmenge mit einem Schwellwert verglichen wird, wobei eine positive Dichtigkeitsinformation bereitgestellt wird, wenn die Durchflussmenge kleiner dem Schwellwert ist.

15. Verfahren nach einem der Ansprüche 13 oder 14, bei dem der Schritt (S4) des Detektierens nach einer Einschwingzeit ausgeführt wird.

## Claims

1. Test system comprising
a wiring network (100) comprising a sealed plug-in connector (104; 204), a charging sockets (102) to be fitted to an at least partially electrically driven vehicle (770) and a cable (106; 206) which connects the plug-in connector (104; 204) and the charging socket (102), wherein the cable (106; 206) has at least one electrical conductor and an insulation which sheaths the at least one electrical conductor, and
a leaktightness test device (110) for the charging socket (102) for supplying electrical power to an energy store (776) of the vehicle (770), comprising
a. a test adapter (112) which makes contact with the sealed plug-in connector (104; 204),
b. a fluid supply (114) which is connected to the test adapter (112) and is designed to provide a fluid (118) to the test adapter (112), and
c. a measuring device (116) for detecting a leaktightness of the charging socket (102) and, optionally, of the wiring network (100) based on the fluid (118) provided.

2. Test system according to Claim 1, wherein the wiring network (100) is a high-voltage wiring network and the test adapter is designed to make contact with the sealed high-voltage plug-in connector.

3. Test system according to either of the preceding claims, in which the test adapter (112) is designed to make contact with at least one second sealed plug-in connector (204) which is connected to the charging socket (102) via at least one second cable (206).

4. Test system according to one of the preceding claims, in which the fluid supply (114) is designed to provide the fluid (118) at least at a pressure of 1.05 times the value of the ambient pressure, or to provide the fluid (118) at least at a pressure of 1.1 times the value of the ambient pressure, or to provide the fluid (118) at least at a pressure of 1.2 times the value of the ambient pressure.

5. Test system according to one of the preceding claims, in which the measuring device (116) comprises a throughflow sensor (120) and is designed to monitor a throughflow quantity and/or a pressure of the fluid (118) provided and to determine the leaktightness using the throughflow quantity and/or the pressure.

6. Test system according to the preceding claim, in which the measuring device (116) is designed to compare the throughflow quantity with a threshold value, wherein the leaktightness is detected when the throughflow quantity, in particular after a settling time, is less than the threshold value.

7. Test system according to one of the preceding claims, in which the fluid (118) is gaseous, in particular in which the fluid (118) comprises helium, hydrogen or substantially air.

8. Test system according to the preceding claim, in which the measuring device (116) comprises a gas sensor (230) in order to detect an emission that indicates a leak.

9. Test system according to one of the preceding claims, in which the measuring device (116) comprises a visual sensor (232, 234) in order to detect an emission that indicates a leak.

10. Test system according to one of the preceding claims, in which high-voltage contact elements (342) for making electrical contact with and testing the wiring network (100) are comprised in the test adapter (112).

11. Method for testing a charging socket (102) for supplying electrical energy to an energy store (776) of a vehicle (770), comprising the following steps:
a. making contact (S1) with a sealed plug-in connector (104; 204) of a wiring network (100) comprising the sealed plug-in connector (104; 204), a charging socket (102) to be fitted to an at least partially electrically driven vehicle (770) and a cable (106; 206) which connects the plug-in connector (104; 204) and the charging socket (102), wherein the cable (106; 206) has at least one electrical conductor and an insulation which sheaths the at least one electrical conductor,
b. providing (S2) a fluid (118) to the sealed plug-in connector (104; 204) by means of a test adapter (112),
c. conducting (S3) the fluid (118) provided from the sealed plug-in connector (104; 204) to the charging socket (102) via the cable (106; 206), and
d. detecting (S4) a leaktightness of the charging socket (102) and, optionally, of the wiring network (100) based on the fluid (118) provided.

12. Method according to Claim 11, in which, in the provision step (S2), the fluid (118) is provided at least at 1.07 times the value of the ambient pressure, in particular the fluid (118) is provided at least at 1.2 times the value of the ambient pressure.

13. Method according to either of Claims 11 and 12, in which, in the detection step (S4), a throughflow quantity and/or a pressure of the fluid provided are/is monitored and a leaktightness is determined using the throughflow quantity and/or the pressure.

14. Method according to Claim 13, in which, in the detection step (S4), the throughflow quantity is compared with a threshold value, wherein an item of positive leaktightness information is provided when the throughflow quantity is less than the threshold value.

15. Method according to either of Claims 13 and 14, in which the detection step (S4) is executed after a settling time.

## Revendications

1. Système de vérification, comprenant
un réseau de distribution (100) comprenant un connecteur enfichable étanche (104 ; 204),
une prise de charge (102) destinée à être montée sur un véhicule (770) à entraînement au moins partiellement électrique ainsi qu'un câble (106 ; 206) reliant le connecteur enfichable (104 ; 204) et la prise de charge (102), le câble (106 ; 206) présentant au moins un conducteur électrique ainsi qu'une isolation enveloppant ledit au moins un conducteur électrique, et
un dispositif de vérification d'étanchéité (110) pour la prise de charge (102), destiné à amener de l'énergie électrique à un accumulateur d'énergie (776) du véhicule (770), comprenant :
a) un adaptateur de vérification (112) qui met en contact le connecteur enfichable étanche (104 ; 204),
b) une alimentation en fluide (114) reliée à l'adaptateur de vérification (112) et qui est aménagée pour fournir un fluide (118) au niveau de l'adaptateur de vérification (112), et
c) un dispositif de mesure (116) pour détecter une étanchéité de la prise de charge (102), et en option du réseau de distribution (100) sur la base du fluide fourni (118).

2. Système de vérification selon la revendication 1, dans lequel le réseau de distribution (100) est un réseau de distribution haute tension et l'adaptateur de vérification est aménagé pour mettre en contact le connecteur enfichable haute tension étanche.

3. Système de vérification selon l'une quelconque des revendications précédentes, dans lequel l'adaptateur de vérification (112) est aménagé pour mettre en contact au moins un deuxième connecteur enfichable (204) étanche qui est relié à la prise de charge (102) par au moins un deuxième câble (206).

4. Système de vérification selon l'une quelconque des revendications précédentes, dans lequel l'alimentation en fluide (114) est aménagée pour fournir le fluide (118) au moins à une pression ayant 1,05 fois la valeur de la pression ambiante, ou pour fournir le fluide (118) au moins à une pression ayant 1,1 fois la valeur de la pression ambiante, ou pour fournir le fluide (118) au moins à une pression ayant 1,2 fois la valeur de la pression ambiante.

5. Système de vérification selon l'une quelconque des revendications précédentes, dans lequel le dispositif de mesure (116) comprend un capteur de débit (120) et est aménagé pour surveiller une capacité de débit et/ou une pression du fluide fourni (118) et pour déterminer l'étanchéité en utilisant la capacité de débit et/ou la pression.

6. Système de vérification selon la revendication précédente, dans lequel le dispositif de mesure (116) est aménagé pour comparer la capacité de débit avec une valeur seuil, l'étanchéité étant détectée lorsque la capacité de débit, en particulier après un temps de stabilisation, est inférieure à la valeur seuil.

7. Système de vérification selon l'une quelconque des revendications précédentes, dans lequel le fluide (118) est gazeux, en particulier dans lequel le fluide (118) comprend de l'hélium, de l'hydrogène ou substantiellement de l'air.

8. Système de vérification selon la revendication précédente, dans lequel le dispositif de mesure (116) comprend un capteur de gaz (230) pour détecter une émission indiquant une fuite.

9. Système de vérification selon l'une quelconque des revendications précédentes, dans lequel le dispositif de mesure (116) comprend un capteur visuel (232, 234) pour détecter une émission indiquant une fuite.

10. Système de vérification selon l'une quelconque des revendications précédentes, dans lequel l'adaptateur de vérification (112) comprend des éléments de contact haute tension (342) pour la mise en contact électrique et la vérification du réseau de distribution (100).

11. Procédé de vérification d'une prise de charge (102) pour amener de l'énergie électrique à un accumulateur d'énergie (776) d'un véhicule (770), comprenant les étapes suivantes consistant à :
a) mettre en contact (S1) un connecteur enfichable étanche (104 ; 204) d'un réseau de distribution (100) comprenant le connecteur enfichable étanche (104 ; 204), une prise de charge (102) destinée à être montée sur un véhicule (770) à entraînement au moins partiellement électrique ainsi qu'un câble (106 ; 206) reliant le connecteur enfichable (104 ; 204) et la prise de charge (102), le câble (106 ; 206) présentant au moins un conducteur électrique ainsi qu'une isolation enveloppant ledit au moins un conducteur électrique,
b) fournir (S2) un fluide (118) au niveau du connecteur enfichable étanche (104 ; 204) au moyen d'un adaptateur de vérification (112),
c) conduire (S3) le fluide fourni (118) du connecteur enfichable étanche (104 ; 204) à la prise de charge (102) en passant par le câble (106 ; 206), et
d) détecter (S4) une étanchéité de la prise de charge (102) et en option du réseau de distribution (100) sur la base du fluide fourni (118).

12. Procédé selon la revendication 11, dans lequel à l'étape (S2) de fourniture, le fluide (118) ayant au moins 1,07 fois la valeur de la pression ambiante est fourni, en particulier le fluide (118) ayant au moins 1,2 fois la valeur de la pression ambiante est fourni.

13. Procédé selon l'une quelconque des revendications 11 ou 12, dans lequel à l'étape (S4) de détection, une capacité de débit et/ou une pression du fluide fourni est/sont surveillée(s) et une étanchéité est déterminée en utilisant la capacité de débit et/ou la pression.

14. Procédé selon la revendication 13, dans lequel à l'étape (S4) de détection, la capacité de débit est comparée à une valeur seuil, une information d'étanchéité positive étant fournie si la capacité de débit est inférieure à la valeur seuil.

15. Procédé selon l'une quelconque des revendications 13 et 14, dans lequel l'étape (S4) de détection est effectuée après un temps de stabilisation.
